(19) **Europäisches Patentamt / European Patent Office / Office européen des brevets**

(11) **EP 2 048 542 A2**

(12) # EUROPEAN PATENT APPLICATION

(43) Date of publication:
**15.04.2009 Bulletin 2009/16**

(51) Int Cl.:
***G03F 9/00*** (2006.01)

(21) Application number: **08253242.5**

(22) Date of filing: **06.10.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **09.10.2007 US 960647 P**

(71) Applicant: **ASML Netherlands B.V.**
**5504 DR Veldhoven (NL)**

(72) Inventors:
• **Mos, Everhardus Cornelis**
**5684 ZJ Best (NL)**

• **Den Boef, Arie Jeffrey**
**5581 NA Waalre (NL)**
• **Van Der Schaar, Maurits**
**5658 AK Eindhoven (NL)**
• **Keij, Stefan Carolus Jacobus Antonius**
**4835 LC Breda (NL)**

(74) Representative: **Leeming, John Gerard**
**J.A. Kemp & Co.**
**14 South Square**
**Gray's Inn**
**London WC1R 5JJ (GB)**

(54) **Alignment method and apparatus, lithographic apparatus, metrology apparatus and device manufacturing method**

(57) An alignment sensor includes a spatially coherent radiation source that supplies a radiation beam to an angle-resolved scatterometer. Alignment is performed by detecting beats in the scatter spectrum during scanning of the substrate relative to the scatterometer.

Fig. 3

EP 2 048 542 A2

**Description**

The present invention relates to methods and apparatus for alignment usable, for example, in the manufacture of devices by lithographic techniques and to methods of manufacturing devices using lithographic techniques.

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Prior to exposing a target portion of the substrate it is desirable to align the target portion to the aerial image to be projected onto it. Originally this was done by lining up a marker on the patterning device (e.g. reticle or mask) with a corresponding marker on the substrate by looking through the projection lens with a microscope or a laser based system. This is known as through-the-lens alignment. At the time of writing however, a process called off-axis alignment is common. This involves using an alignment system to measure the relative positions of alignment markers on a substrate held on a substrate table relative to one or more permanent reference markers or fiducials mounted on the substrate table, prior to transferring the substrate table with substrate to an exposure station. At the exposure station it is only desirable to determine the relevant position of the fiducial(s) to the aerial image of the pattern to be exposed. Then, a trajectory for the substrate table to correctly position each target portion for exposure may be calculated.

Various types of alignment system are known. In one, the alignment marker on the substrate is a grating which is illuminated by an inspection beam. The different orders diffracted by the grating are separated and corresponding orders recombined (i.e. +n combined with -n) to form images of the alignment markers overlying corresponding transmissive reference gratings. As the substrate is scanned relative to the system, the signals output by sensors behind the reference gratings oscillate as the images and reference gratings move into and out of phase. Multiple gratings of different pitch allow the center period to be captured and multiple samples during a scan allow an alignment accuracy much better than the grating pitch. It is known to use two different wavelengths to enable alignment with markers in complex process stacks. Another form of alignment sensor uses a self-referencing interferometer to overly an image of the alignment marker with a copy of that image rotated by 180°. This has the benefit that it may be used with any marker that is 180° rotationally symmetric, not just gratings.

While known alignment sensors are fast and accurate, the continual desire to increase the density of features in semiconductor devices leads to the need to improve alignment systems, for example to enable use of smaller alignment markers, different wavelengths of radiation and to detect "weaker" markers (e.g. markers with reduced feature height, or due to the effects of overlying layers and/or processes carried out on the substrate).

It is desirable to provide an improved alignment system, e.g. for use in manufacture of devices by lithographic techniques.

According to an aspect of the invention, there is provided an alignment apparatus configured to detect an alignment marker on a substrate, the apparatus including: a spatially coherent radiation source configured to emit a beam of radiation; an objective lens configured to direct the beam of radiation onto the marker on the substrate and to collect radiation diffracted by the marker; a sensor configured to detect an angle resolved spectrum in a pupil plane of the objective lens; and a control circuit arranged to detect spatial and/or temporal variations in the detected angle-resolved spectrum and to derive therefrom information indicative of the position of the alignment marker relative to the objective lens.

According to an aspect of the invention, there is provided a lithographic apparatus including: an illumination optical system arranged to illuminate a pattern; a projection optical system arranged to project an image of the pattern on to a substrate; an alignment system configured to detect an alignment marker on a substrate, the apparatus including: a spatially coherent light source configured to emit a beam of radiation; an objective lens configured to direct the beam of radiation onto the marker on the substrate and to collect radiation diffracted by the marker; a sensor configured to detect an angle resolved spectrum in a pupil plane of the objective lens; and a control circuit configured to detect spatial and/or temporal variations in the detected angle-resolved spectrum and a positioning system responsive to the detection of the alignment marker by the alignment system and configured to position the substrate in the image field of the projection system.

According to an aspect of the invention, there is provided a metrology apparatus configured to measure a property of a substrate, the apparatus including: a sensor system arranged to measure a property of a target at a known location on the substrate; an alignment system configured to detect an alignment marker on a substrate, the apparatus including: a spatially coherent light source configured to emit a beam of radiation; an objective lens configured to direct the beam of radiation onto the marker on the substrate and to collect radiation diffracted by the marker; a sensor configured to detect an angle resolved spectrum in a pupil plane of the objective lens; and a control circuit configured to detect spatial and/or temporal variations in the detected angle-resolved; and a positioning system responsive to the detection of the alignment marker by the alignment system and configured to position the substrate in the field of view of the sensor system.

According to an aspect of the invention, there is provided a method of detecting the position of a marker on a substrate, the method including: illuminating the marker with a spatially coherent radiation beam; collecting radiation diffracted from the marker using an objective lens; detecting an angle-resolved spectrum in a pupil plane of the objective lens; relatively moving the substrate and the objective lens; and detecting oscillating signals in the angle-resolved spectrum.

According to an aspect of the invention, there is provided a device manufacturing method using a lithographic apparatus having a projection system, the method including: detecting the position of a marker on a substrate by: illuminating the marker with a spatially coherent radiation beam; collecting radiation diffracted from the marker using an objective lens; detecting an angle-resolved spectrum in a pupil plane of the objective lens; relatively moving the substrate and the objective lens; and detecting oscillating signals in the angle-resolved spectrum; positioning the substrate relative to the projection system by reference to the detected position of the marker; projecting an image of a pattern onto the substrate using the projection system.

Embodiments of the invention will now be described, by way of example only, with reference to the accompanying schematic drawings in which corresponding reference symbols indicate corresponding parts, and in which:

Figure 1 depicts a lithographic apparatus according to an embodiment of the invention;

Figure 2 depicts a lithographic cell or cluster;

Figure 3 depicts an alignment sensor according to an embodiment of the invention;

Figure 4 depicts the radiation source of the alignment sensor of Figure 3; and

Figure 5 depicts a supercontinuum laser.

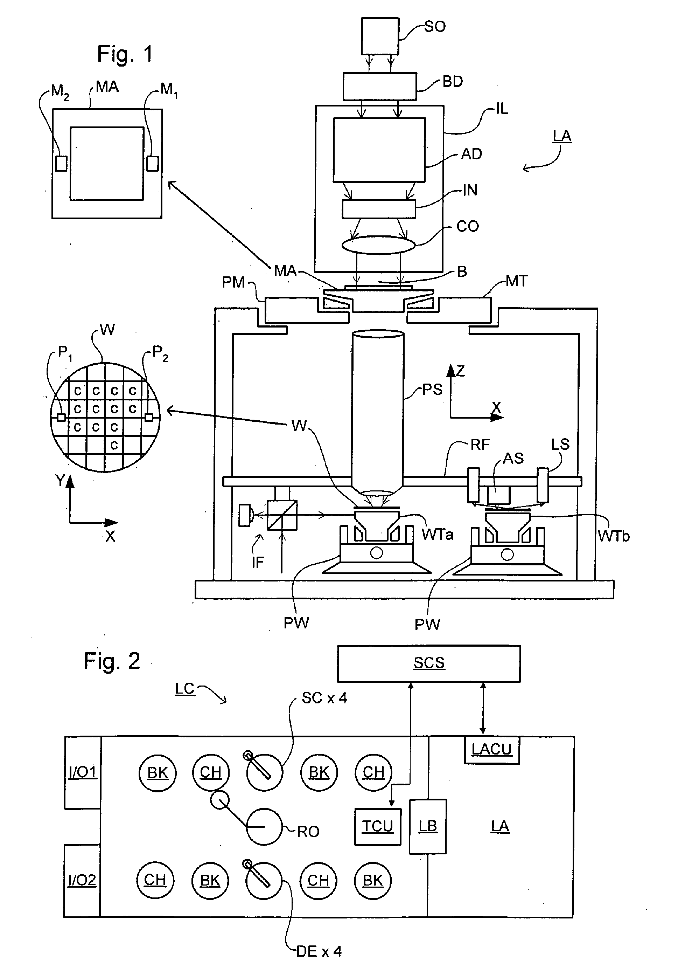

Figure 1 schematically depicts a lithographic apparatus LA. The apparatus includes an illumination system (illuminator) IL configured to condition a radiation beam B (e.g. UV radiation or DUV radiation), a support structure (e.g. a mask table) MT constructed to support a patterning device (e.g. a mask) MA and connected to a first positioner PM configured to accurately position the patterning device in accordance with certain parameters; a substrate table (e.g. a wafer table) WTa or WTb constructed to hold a substrate (e.g. a resist-coated wafer) W and connected to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. including one or more dies) of the substrate W. The lithographic apparatus LA also includes a reference frame RF.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross-section.

The radiation beam B is incident on the patterning device (e.g., mask) MA, which is held on the support structure (e.g., mask table) MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g. an interferometric device, linear encoder, 2-D encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g. after mechanical retrieval from a mask library, or during a scan. In general, movement of the support structure (e.g. mask table) MT may be realized with the aid of a long-stroke module (coarse positioning) and a short-stroke module (fine positioning), which form part of the first positioner PM. Similarly, movement of the substrate table WTa and/or WTb may be realized using a long-stroke module and a short-stroke module, which form part of the second positioner PW. In the case of a stepper (as opposed to a scanner) the support structure (e.g. mask table) MT may be connected to a short-stroke actuator only, or may be fixed.

Patterning device (e.g. mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g. mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

The depicted apparatus could be used in at least one of the following modes:

1. In step mode, the support structure (e.g. mask table) MT and the substrate table WT are kept essentially stationary, while an entire pattern imparted to the radiation beam is projected onto a target portion C at one time (i.e. a single static exposure). The substrate table WTa and/or WTb is then shifted in the X and/or Y direction so that a different target portion C can be exposed. In step mode, the maximum size of the exposure field limits the size of the target portion C imaged in a single static exposure.

2. In scan mode, the support structure (e.g. mask table) MT and the substrate table WTa and/or WTb are scanned synchronously while a pattern imparted to the radiation beam is projected onto a target portion C (i.e. a single dynamic exposure). The velocity and direction of the substrate table WTa and/or WTb relative to the support structure (e.g. mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure (e.g. mask table) MT is kept essentially stationary holding a programmable patterning device, and the substrate table WTa and/or WTb is moved or scanned while a pattern imparted to the radiation beam is projected onto a target portion C. In this mode, generally a pulsed radiation source is employed and the programmable patterning device is updated as required after each movement of the substrate table WTa and/or WTb or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Lithographic apparatus LA is of a so-called dual stage type which has two substrate tables WTa, WTb and two stations - an exposure station and a measurement station - between which the substrate tables can be exchanged. While one substrate or one substrate table is being exposed at the exposure station, another substrate may be loaded onto the other substrate table at the measurement station and various preparatory procedures carried out. The preparatory procedures may include mapping the surface control of the substrate using a level sensor LS and measuring the position of alignment markers on the substrate using an alignment sensor AS. This enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

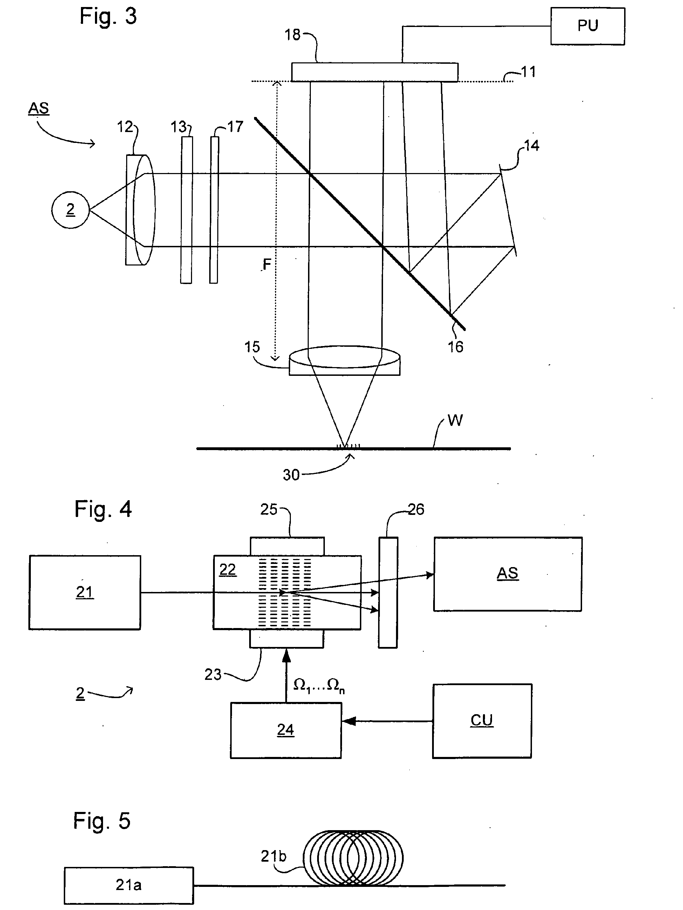

The alignment sensor AS, which is a form of scatterometer, is shown in Figure 3. In this sensor, the radiation emitted by radiation source unit 2 (described further below) is focused using lens system 12 through element 13 and (optional) polarizer 17, reflected by partially reflective surface 16 and is focused onto substrate W via a microscope objective lens 15, which has a high numerical aperture (NA), preferably at least 0.9 and more preferably at least 0.95. Immersion sensors may even have lenses with numerical apertures over 1. Lens system 12 is arranged to provide a desired illumination mode, e.g. annular or conventional, and preferably so that the parameters of that mode, e.g. $\sigma_{inner}$, $\sigma_{outer}$ or $\sigma$, are adjustable. The reflected radiation then transmits through partially reflective surface 16 into a detector 18 in order to have the scatter spectrum detected. The detector may be located in the back-projected pupil plane 11, which is at the focal length of the lens system 15, however the pupil plane may instead be re-imaged with auxiliary optics (not shown) onto the detector. The detector 18 is in communication with processing unit PU. The pupil plane is a plane in which the radial position of radiation defines the angle of incidence on the substrate and the angular position defines azimuth angle of the radiation. The detector is preferably a two-dimensional detector so that a two-dimensional angular scatter spectrum of the substrate target can be measured. The detector 18 may be, for example, an array of CCD or CMOS sensors, and may use an integration time of, for example, 1 millisecond per frame or less.

A reference beam is often used for example to measure the intensity of the incident radiation. To do this, when the radiation beam is incident on the beam splitter 16 part of it is transmitted through the beam splitter as a reference beam towards a reference mirror 14. The reference beam is then projected onto a different part of the same detector 18.

The detector 18 may measure the intensity of scattered light at a single wavelength (or narrow wavelength range), the intensity separately at multiple wavelengths or integrated over a wavelength range. Furthermore, the detector may separately measure the intensity of transverse magnetic- and transverse electric-polarized.

The target 30 on substrate W is an alignment marker in the form of a grating. Usually, in scatterometry, the scatterometry data of the target is used to reconstruct it. However, as discussed below, the present invention enables detection of the centre position of the marker without reconstruction of the marker.

The radiation source unit 2 is shown in more detail in Figure 4. The source includes a spatially coherent source 21, such as for example a laser diode (preferably super-luminescent) or a supercontinuum laser, which directs light into an acousto-optical tunable filter (AOTF), a grating or a set of exchangeable interference filters, which is used to select a narrow range of wavelengths from the broadband (white light) output of the source 21 to form the inspection beam in the remainder of the sensor, depicted AS in Figure 4.

The acousto-optical tunable filter includes an acousto-optical crystal 22 to which are connected a piezoelectric transducer 23, driven by a high-frequency driver circuit 24, and an acoustic absorber 25. Transducer 23 creates acoustic waves in the crystal 22 with a wavelength determined by the mechanical properties (speed of sound) of the crystal and driving frequencies. As these waves propagate through the crystal they form a periodic redistribution of the refractive index of the crystal due to the alternating expansion and contraction of the crystal lattice. This forms a diffraction grating which diffracts the light passing through it, although diffraction occurs throughout the region of interaction rather than at a single point and only radiation meeting phase and/or momentum matching conditions is diffracted. The net effect is that radiation of a narrow band of wavelengths is diffracted away from the main beam and can be selected by a spatial and/or polarizing filter 26. The center wavelength of the diffracted beam is dependent on the driving frequency of the transducer so it can be controlled within quite a wide range and very rapidly, dependent on the response time of the driver circuit 25, the transducer and the crystal. The intensity of the diffracted beam is also controlled by the intensity of the acoustic waves.

Suitable materials which can be used for the acousto-optical crystal include: Quartz ($SiO_2$), KDP ($KH_2PO_4$), Paratellurite or tellurium dioxide ($TeO_2$), $LiNbO_3$, calomel or mercuric chloride ($Hg_2Cl_2$), TAS ($Ta_3AsSe_3$) and Te (tellurium), magnesium fluoride ($MgF$), and sapphire (aluminum oxide, $Al_2O_3$). The crystal selected determines the detailed geometry of the acousto-optical tunable filter. If a birefringent crystal is used, the filter may also select a particular polarization state.

High frequency drive unit 24 is connected to the control unit CU of the scatterometer which provides a drive signal to cause the transducer to emit acoustic waves of an appropriate frequency to select a narrow band of wavelengths centered on a desired wavelength, as required for a given measurement. The bandwidth of the transmitted beam is preferably less that 20nm, less than 15nm, less than 10nm or less than 5nm. The exact relationship between frequency of drive signal and selected wavelength depends on the particular crystal employed and the geometry of the device. In some cases, by applying a drive signal having two or more components of different frequencies $\Omega_l$ to $\Omega_n$, the filter can be operated to select a plurality of components each centered around a different wavelength, which forms a polychromatic beam that allows a plurality of measurements to be made simultaneously. The intensities of the different frequency components of the drive signal may be varied to individually control the intensities of the different wavelengths in the polychromatic beam.

A light source that may be used in an embodiment of the present invention is a supercontinuum laser, which is illustrated in Figure 5. This source includes a pulsed laser source 21a whose output is fed into a non-linear medium 21 b, e.g. a photonic crystal fiber. The pulsed source 21a emits very short pulses, e.g. of femtosecond or picosecond duration, of a narrow band of wavelengths which are spread by the non-linear medium 21 b into a broadband beam of radiation. This type of source may provide a powerful beam with a low etendue and a suitable range of wavelengths.

To detect the position of an adjustment marker, the substrate is scanned beneath the alignment sensor AS in a similar manner as is done with prior art alignment sensors. As the scan is performed, certain parts of the spectrum detected by detector 18 will exhibit intensity oscillators in synchronism with the relative movement of the substrate and objective lens 15. This oscillatory signal and knowledge of the accompanying substrate movement can be processed, in the same way as in the prior art to determine the centre of the mark. As in the prior art, the oscillating signal has a periodicity related to the pitch of the target grating so, again, two gratings of slightly different pitch can be used to identify the centre period. The generation of the oscillating signals may be explained in two ways, which are equivalent but different views of the same physical phenomenon.

The target grating is illuminated by a cone of light (hollow in the case of annular illumination and solid in the case of conventional illumination). Because the source is spatially coherent, there will be interference between rays arriving from opposite sides of the cone and therefore an interference pattern will be formed. If that interface pattern has the correct pitch, determined by the wavelength of the radiation and the angle of the incident rays, relative to that of the gratings, beats in the intensity in the pupil plane will be formed on relative movement of the grating and the interference pattern. The periodicity of the beats depends on which diffraction orders are being detected in the pupil plane: if diffraction orders n and m are used the pitch of the beats is equal to the pitch of the grating divided by the magnitude of the difference between n and m.

Another way of looking at the situation is that the grating diffracts radiation into various different orders 0, $\pm$ 1, etc. which will partially overlap in the pupil plane. The spatial coherence of the source means that the there will be interference between the overlapping orders. Relative movement of the grating and the objective lens will cause the phase of the different orders to change and because the phase changes of the different orders are different, oscillatory intensity variations will arise. The phase difference ($\phi_n - \phi_m$) between the different orders, m and n, contains information on the position, x, of the alignment marker, in particular:

$$x = p \frac{(\varphi_n - \varphi_m)}{2.\pi(n-m)} \qquad \textbf{(1)}$$

where p is the pitch of the target grating.

The position in the pupil plane and amplitude of the beats occurring on relative motion of the target and objective lens may be dependent on a number of factors including the illumination mode - especially $\sigma$ or $\sigma_{outer}$ - the wavelength of the radiation, and the grating strength (depth/height of tracks or lines forming the gratings). In the embodiment of the invention the wavelength of the radiation may be adjusted using the AOTF and the illumination mode via lens system 12 so that the strength of the beat signals can be optimized. In some cases, e.g. with strong gratings, the maximum signal can be obtained by using annular illumination with $\sigma_{outer}$ and the wavelength selected to form an interference pattern of the same pitch as the target grating. Beats will appear where the +1st and -1st orders overlap. In other cases, e.g. with weak gratings, beats are strongest where the 0th and +/-1st orders overlap so conventional illumination is preferred to obtain a strong 0th order.

It will be appreciated that the beats are only observed in localized parts of the pupil plane. In some cases the location of the beat signal can be calculated in advance so that only data of a few pixels from the CCD need be recorded or processed. In other cases, e.g. where the exact pitch of the grating is not known, the exact location may not be identified in advance. However, signal processing techniques may be applied to the whole, or parts of, the CCD image to identify the location of the beats. By recording a series of CCD images and the corresponding stage position, it becomes possible to perform the measuring processes offline so that throughput is not reduced.

In the event that the beat signal has a poor signal to noise ratio, e.g. due to shot noise in the source, the reference beam or a part of the CCD image that does not exhibit beats may be used to normalize the signal and reduce noise.

In an embodiment of the invention, it is desirable to position the substrate so that the target is out of focus in the sensor. In this way, it is possible to generate a fringe pattern in the areas of overlapping diffraction orders from which the position of the grating can be determined without scanning the substrate. Also, the spot size on the target is increased which improves averaging over line-edge roughness.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin film magnetic heads, etc.. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

**Claims**

1. An alignment apparatus configured to detect an alignment marker on a substrate, the apparatus comprising:

   a spatially coherent radiation source configured to emit a beam of radiation;
   an objective lens configured to direct the beam of radiation onto the marker on the substrate and to collect radiation diffracted by the marker;
   a sensor configured to detect an angle resolved spectrum in a pupil plane of the objective lens; and
   a control circuit arranged to detect spatial, or temporal variations or both in the detected angle-resolved spectrum and to derive therefrom information indicative of the position of the alignment marker relative to the objective lens.

2. An apparatus according to claim 1, further comprising:

   a positioner configured to effect relative movement between the substrate and the objective lens, wherein the control circuit is arranged to detect variations in the detected angle-resolved spectrum synchronous with relative movement of the substrate and objective lens; and/or
   a positioner configured to position the substrate at a position that is out of focus of the objective lens, wherein the control circuit is arranged to detect fringes in the detected angle-resolved spectrum.

3. An apparatus according to claim 1, or 2,wherein the radiation source comprises:

   a broadband radiation source arranged to emit a first beam of radiation having a first wavelength range; and
   a filter device arranged to select as an output beam a beam of radiation having a second wavelength range, the second wavelength range being narrower than the first wavelength range.

4. An apparatus according to claim 4, wherein the filter device comprises:

   an acousto-optical tunable filter comprising an acousto-optical crystal arranged to receive the first beam of radiation, a transducer coupled to the acousto-optical filter and arranged to excite acoustic waves therein and a beam selecting device arranged to select as the output beam one of a plurality of beams output by the acousto-optical crystal in response to the first beam and the acoustic waves as a second beam of radiation having a second wavelength range, the second wavelength range being narrower than the first wavelength range; or
   a diffraction grating; or
   a set of exchangeable interference filters.

5. An apparatus according to claim 4 or 5, wherein the broadband radiation source is selected from the group consisting of a supercontinuum laser, a laser diode, and a super-luminescent diode.

6. An apparatus according to any one of the preceding claims, wherein the sensor is selected from the group consisting of a CCD camera and a CMOS sensor.

7. An apparatus according to any one of the preceding claims, wherein the radiation source comprises a beam conditioning optical system configured to provide annular illumination of the marker.

8. An apparatus according to claim 7, wherein the objective lens has a numeric aperture sufficient to capture at least part of +1 and -1 diffraction orders from the marker.

9. An apparatus according to claim 8, wherein the control circuit is configured to detect oscillations in a part of the detected angle-resolved spectrum in which the $+1^{st}$ and $-1^{st}$ diffraction orders overlap and/or a part of the detected angle-resolved spectrum in which the $0^{th}$ and at least one of the $+1^{st}$ and $-1^{st}$ diffraction orders overlap.

10. An apparatus according to any one of the preceding claims, wherein the radiation source comprises an adjustable beam conditioning optical system configured to illuminate the substrate in a desired illumination mode.

11. A lithographic apparatus comprising:

an illumination system arranged to illuminate a pattern;
a substrate table configured to hold a substrate;
a projection system arranged to project an image of the pattern onto the substrate;
an alignment system according to any one of the preceding claims; and
a positioning system responsive to the detection of the alignment marker by the alignment system and configured to position the substrate in an image field of the projection system; the apparatus optionally further comprising g an exposure station and a measurement station, the substrate table being moveable between the exposure station and the measurement station, and the alignment apparatus being positioned at the measurement station.

12. A metrology apparatus configured to measure a property of a substrate, the apparatus comprising:

a sensor system arranged to measure a property of a target at a known location on the substrate;
an alignment system according to any one of the preceding claims; and
a positioning system responsive to the detection of the alignment marker by the alignment system and configured to position the substrate in a field of view of the sensor system.

13. A method of detecting the position of a marker on a substrate, the method comprising:

illuminating the marker with a spatially coherent radiation beam;
collecting radiation diffracted from the marker using an objective lens;
detecting an angle-resolved spectrum in a pupil plane of the objective lens;
relatively moving the substrate and the objective lens; and
detecting oscillating signals in the angle-resolved spectrum.

14. A method according to claim 13, wherein illuminating the marker comprises:

providing annular illumination of the marker and detecting oscillating signals comprises detecting oscillations in a part of the spectrum in which +1st and -1st diffraction orders from the marker overlap; or
providing full pupil illumination of the marker and detecting oscillating signals comprises detecting oscillations in at least a part of the spectrum in which the 0th and at least one of the +1st and -1st diffraction orders from the marker overlap.

15. A device manufacturing method using a lithographic apparatus having a projection system, the method comprising:

detecting the position of a marker on a substrate, the detecting including
illuminating the marker with a spatially coherent radiation beam;
collecting radiation diffracted from the marker using an objective lens;
detecting an angle-resolved spectrum in a pupil plane of the objective lens;
relatively moving the substrate and the objective lens; and
detecting oscillating signals in the angle-resolved spectrum;
positioning the substrate relative to the projection system by reference to the detected position of the marker, and projecting an image of a pattern onto the substrate using the projection system.

Fig. 1

Fig. 2

## Fig. 3

## Fig. 4

## Fig. 5